# EUROPEAN PATENT APPLICATION

(11) **EP 4 095 927 A1**
(43) Date of publication of application: **30.11.2022**
(21) Application number: 21764865.8
(22) Date of filing: 04.03.2021
(51) Int. Cl.: H01L 29/06, H01L 29/872, H01L 29/16

(54) **METHOD OF MANUFACTURING SUPER JUNCTION, AND SUPER JUNCTION SCHOTTKY DIODE USING SAME**

(30) Priority: 06.03.2020 CN 202010150476
(71) Applicant: Inventchip Technology Co., Ltd., Shanghai 201306 (CN)
(72) Inventor: CHEN, Wei, Pudong New District Shanghai 201306 (CN); ZHONG, Xueqian, Pudong New District Shanghai 201306 (CN); HUANG, Haitao, Pudong New District Shanghai 201306 (CN)
(74) Representative: FARAGO Patentanwaltsgesellschaft mbH
(86) International application number: PCT/CN2021/079118
(87) International publication number: WO 2021/175294

(57) **Abstract**

The present invention relates to the field of semiconductors, and discloses a manufacturing method of a super junction and a super-junction Schottky diode thereof. The manufacturing method of the super junction in the present application includes: forming an epitaxial layer on the surface of a wide-bandgap semiconductor substrate by an epitaxial growth process; implanting first doping ions into at least part of region of the epitaxial layer along a preset crystal orientation of the wide-bandgap semiconductor to form a first conductive type region; and implanting second doping ions into at least part of the first conductive type region along the preset crystal orientation of the wide-bandgap semiconductor to form a second conductive type region, wherein the second doping ions and the first doping ions have different conductive types, and the preset crystal orientation is a crystal orientation which enables the doping ions to generate a channel effect when the doping ions are implanted along the preset crystal orientation.

## Description

The present application is based on and claims priority to the Chinese invention patent application No. 202010150476.9, which was filed on March 6, 2020 to CNIPA and titled "Manufacturing Method of Super Junction and Super-junction Schottky Diode". The application is incorporated herein by reference in its entirety.

### Technical Field

The present application relates to the field of semiconductors, and specially relates to a manufacturing method of a super junction and a super-junction Schottky diode thereof.

### Background Art

Wide-bandgap power semiconductor devices are increasingly widely applied in various power systems owing to their excellent properties such as larger bandgap width, higher critical breakdown field strength, and stronger thermal conductivity. However, with the gradual maturity in technology of conventional silicon carbide power devices (especially silicon carbide diodes), high cost has become an obstacle to its further expansion of application scale. One of the key ways to reduce the cost is to continuously reduce a characteristic on-resistance, thereby improving the through-current capability per unit area and ultimately reducing a chip area. The super junction technology is the most effective means to achieve the above ways. However, it is well known that the manufacture of super junction structures in silicon carbide materials presents considerable technical difficulties. A multiple epitaxy technology, a trench etching and epitaxial backfill technology and the like, which are widely used in silicon-based super junction devices, are difficult to be directly applied to the preparation of silicon carbide super junction devices due to high process cost, difficult process control and the like.

### Summary of the Invention

In order to solve the above problems in the prior art, the present invention provides a manufacturing method of a super junction and a super-junction Schottky diode thereof. This manufacturing method can greatly reduce the manufacturing difficulty of a wide-bandgap semiconductor super junction power semiconductor device, and has excellent process consistency and reduced manufacturing cost.

According to a first aspect, an embodiment of the present application provides a manufacturing method of a super junction. The method includes:
forming an epitaxial layer on the surface of a wide-bandgap semiconductor substrate by an epitaxial growth process;
implanting first doping ions into at least one part of region of the epitaxial layer along a preset crystal orientation of the wide-bandgap semiconductor to form a first conductive type region; and
implanting second doping ions into at least part of the first conductive type region along the preset crystal orientation of the wide-bandgap semiconductor to form a second conductive type region, wherein the second doping ions and the first doping ions have different conductive types; and
the preset crystal orientation is a crystal orientation which enables the doping ions to generate a channel effect when the doping ions are implanted along the preset crystal orientation.

In a possible implementation of the first aspect, the wide-bandgap semiconductor is silicon carbide, and the preset crystal orientation of the wide-bandgap semiconductor is a C-axis direction of the silicon carbide.

In a possible implementation of the first aspect, the silicon carbide includes 4H-SiC or 6H-SiC.

In a possible implementation of the first aspect, the step of implanting the first doping ions into at least part of region of the epitaxial layer along the crystal orientation of the wide-bandgap semiconductor includes:
implanting the first doping ions into at least part of region of the epitaxial layer along the crystal direction of the wide-bandgap semiconductor at a first concentration and a first energy, as well as at a second concentration and a second energy, respectively.

In a possible implementation of the first aspect, the first concentration is 1E13 to 3E14 atoms per square centimeter, and the first energy is 500 kev to 2000 kev; and the second concentration is 1E12 to 5E13 atoms per square centimeter, and the second energy is 50 kev to 300 kev.

In a possible implementation of the first aspect, the step of implanting the second doping ions into at least part of the first conductive type region along the crystal orientation of the wide-bandgap semiconductor includes:
implanting the second doping ions into at least part of region of the epitaxial layer along the crystal direction of the wide-bandgap semiconductor at a third concentration and a third energy, as well as a fourth concentration and a fourth energy, respectively.

In a possible implementation of the first aspect, the third concentration is 5E13 to 3E14 atoms per square centimeter, and the third energy is 500 kev to 2000 kev; and the fourth concentration is 5E12 to 5E13 atoms per square centimeter, and the fourth energy is 50 kev to 300 kev.

In a possible implementation of the first aspect, the first doping ions include nitrogen ions or phosphorus ions.

In a possible implementation of the first aspect, the second doping ions include aluminum ions or boron ions.

According to a second aspect, an embodiment of the present application provides a super-junction Schottky diode. The super-junction Schottky diode includes:
an epitaxial layer formed on the surface of a wide-bandgap semiconductor substrate by an epitaxial growth process;
a first conductive type region formed by implanting first doping ions into at least part of region of the epitaxial layer along a preset crystal orientation of the wide-bandgap semiconductor;
a second conductive type region formed by implanting second doping ions into at least part of the first conductive type region along the preset crystal orientation of the wide-bandgap semiconductor;
a metal layer disposed on at least part of the surface of the first conductive type region away from the substrate, such that the metal layer and the first conductive type region form a Schottky junction, wherein
the preset crystal orientation is a crystal orientation which enables the doping ions to generate a channel effect when the doping ions are implanted along the preset crystal orientation.

In a possible implementation of the second aspect, the super-junction Schottky diode further includes: a second conductive type implantation region formed by implanting the second doping ions into part of the second conductive type region along a normal direction of the wide-bandgap semiconductor.

In a possible implementation of the second aspect, the wide-bandgap semiconductor is silicon carbide.

In a possible implementation of the second aspect, the silicon carbide includes 4H-SiC or 6H-SiC.

In a possible implementation of the second aspect, the first ions include nitrogen ions or phosphorus ions; and the nitrogen ions or phosphorus ions are implanted into at least part of region of the epitaxial layer along a C-axis direction of the silicon carbide semiconductor at a first concentration and a first energy, as well as at a second concentration and a second energy, respectively.

In a possible implementation of the second aspect, the second doping ions include aluminum ions or boron ions; and the aluminum ions are implanted into at least part of the first conductive type region along the C-axis direction of the silicon carbide semiconductor at a third concentration and a third energy, as well as at a fourth concentration and a fourth energy, respectively.

In a possible implementation of the second aspect, the second doping ions include aluminum ions or boron ions; and the aluminum ions are implanted into part of the second conductive type region along a normal direction of the wide-bandgap semiconductor at a fifth concentration and a fifth energy, as well as at a sixth concentration and a sixth energy, respectively.

### Brief Description of the Drawings

FIG. 1 shows a flowchart of a manufacturing method of a super junction according to some embodiments of the present application;
FIGS. 2a-2g show schematic structural diagrams of a super-junction Schottky diode corresponding to one or more steps shown in FIG. 1, according to some embodiments of the present application; and
FIG. 3 shows a schematic diagram of a crystal orientation of a silicon carbide semiconductor according to some embodiments of the present application.

### Detailed Description of the Invention

Illustrative embodiments of the present application include, but are not limited to, a manufacturing method of a super junction and a super-junction Schottky diode thereof.

The embodiments of the present application will be described below with reference to the accompanying drawings.

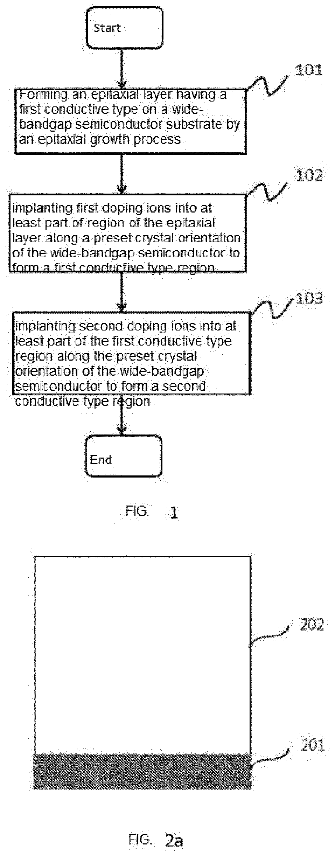

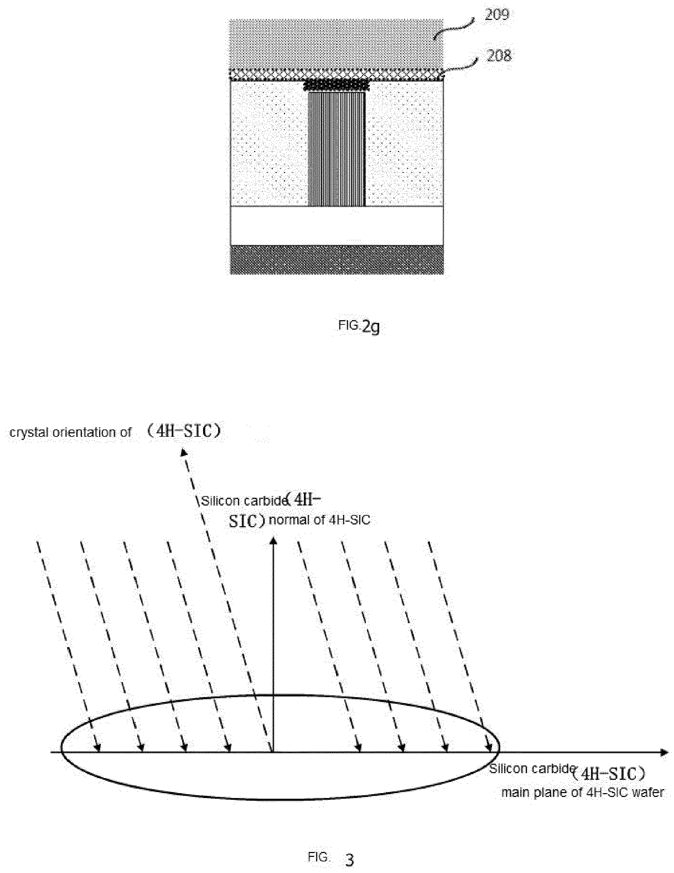

According to some embodiments of the present application, FIG. 1 schematically shows a schematic flowchart of a manufacturing method of a super junction. Specifically, as shown in FIG. 1, the method includes the following steps.
(1) An epitaxial layer (101) is formed on the surface of a wide-bandgap semiconductor substrate by an epitaxial growth process, wherein the wide-bandgap semiconductor includes, but is not limited to, silicon carbide, gallium nitride, aluminum nitride or diamond, etc., which are not limited herein. The epitaxial growth process refers to growing a single crystal layer of the same crystal orientation as the wide-bandgap semiconductor substrate by means of vapor phase epitaxy, liquid phase epitaxy, molecular beam epitaxy or the like along the original crystal orientation of the wide-bandgap semiconductor substrate. In the embodiments of the present application, the conductivity type of the epitaxial layer may be the same as or different from the conductivity type of the wide-bandgap semiconductor substrate, which is not limited herein.
(2) First doping ions are implanted into at least part of region of the epitaxial layer along a preset crystal direction of the wide-bandgap semiconductor to form a first conductivity type region (102), wherein the preset crystal orientation is a crystal orientation in which a channel effect will occur when the first doping ions are implanted along the preset crystal orientation. The channel effect refers to the implantation of ions into a solid, such that ions collide with the atoms of the solid. If the solid is amorphous, the atoms that make up the solid are randomly distributed in space. Therefore, the collision between the ions and target atoms is random, and the size of a collision parameter P is a random parameter. If the solid is a crystal, the atoms are regularly arranged in space. When ions are implanted along a main crystallographic axis of the crystal, they may collide with lattice atoms similarly (the collision parameter P is approximately equal). The collisions are related to each other, and with each collision, the motion of the ions is deflected very little. The ions pass near the same row of atoms in the lattice and can penetrate deeper distances into the solid. In the embodiments of the present application, since the wide-bandgap semiconductor substrate is a single crystal, internal atoms are regularly arranged. Therefore, the first doping ions can have a channel effect along the preset crystal direction and penetrate a relatively deep distance.
   When the first doping ions are implanted along a crystal orientation of the wide-bandgap semiconductor, due to the channel effect, the first doping ions have a longer range in the epitaxial layer than when implanted in random directions or along a normal direction of a wafer, and have stronger penetration, thereby reducing the ion implantation energy and the manufacturing cost. In some embodiments, the wide-bandgap semiconductor may be silicon carbide, and the crystal orientation of the wide-bandgap semiconductor may be selected as a C-axis direction of silicon carbide. As shown in FIG. 3, a normal of a 4H-SiC wafer is perpendicular to a main plane of the 4H-SiC wafer, while an included angle between the C-axis and the normal of the 4H-SiC wafer is 4 degrees.
(3) Second doping ions are implanted into at least part of the first conductive type region along a preset crystal orientation of the wide-bandgap semiconductor to form a second conductive type (103), wherein the preset crystal orientation is a crystal orientation in which the channel effect will occur when the first doping ions are implanted along the preset crystal orientation, and the implantation direction of the second doping ions is the same as that of the first doping ions, such that when the second doping ions are implanted into the first conductive type region, the channel effect is fully utilized to form a deeper second conductive type region, but less energy is required for implantation. It can be understood that the conductivity type of the second doping ions is different from that of the first doping ions. For example, the first doping ions are N-type ions (nitrogen ions or phosphorus ions), and the second doping ions are P-type ions (aluminum ions or boron ions), which are not limited herein.

According to the above method, the super junction formed by the first conductivity type region and the second conductivity type region may be applied to various power semiconductor devices, such that a characteristic on-resistance of the device is reduced, thereby reducing the chip area and the cost of the wide-bandgap power semiconductor device while optimizing the performances of the device.

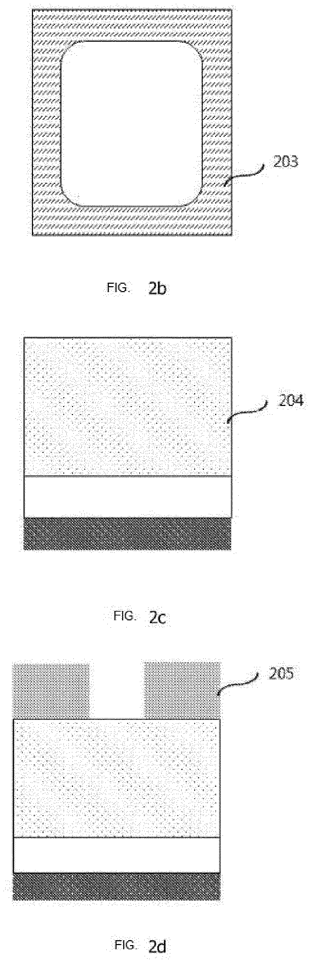

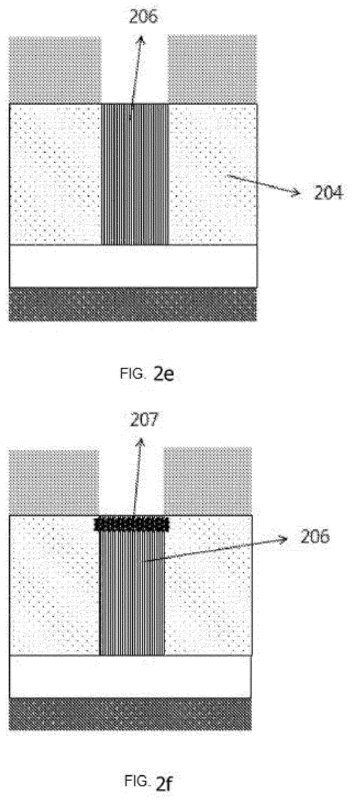

A schematic diagram of a super-junction Schottky diode corresponding to one or more steps in the flowchart of the manufacturing method of the super junction shown in FIG. 1 is described below with reference to FIGS. 2a-2g. In FIGS. 2a-2g, the manufacturing process of the Schottky diode with the super junction of the present application will be specifically described by taking the wide-bandgap semiconductor substrate being made of a silicon carbide material, the first conductivity type is an N type, the second conductivity type is a P type, the first conductivity type region is an N type implantation region, the second conductivity type region being a P type column, the first doping ions being nitrogen ions or phosphorus ions, and the second doping ions being aluminum ions or boron ions as examples. The following steps are included.
(1) An epitaxial layer 202 is grown first. Referring to FIG. 2a, a lightly doped N-type epitaxial layer 202 is grown on a heavily doped N-type silicon carbide substrate 201 by an epitaxial growth process. It can be understood that heavy doping differs from light doping in that a heavily doped ion concentration is higher than a lightly doped ion concentration. In some embodiments, the N-type doping concentration of the epitaxial layer 202 is between 1E14 atoms per square centimeter and 5E16 atoms per square centimeter, and the thickness of the epitaxial layer 202 is between 1 um and 200 um. It can be understood that the thickness and doping concentration of the N-type epitaxial layer can be determined according to a withstand voltage rating of the device. N-type doping ions include, but are not limited to, nitrogen ions or phosphorus ions, etc., which are not limited herein.
(2) A mask layer 203 is formed. Referring to FIG. 2b, in one embodiment, an inorganic thin film material that can be formed on the surface of the N-type epitaxial layer 202 by means of chemical vapor deposition (CVD) is used as the hard mask layer 203. The components of the inorganic thin film material include, but are not limited to, silicon dioxide, silicon nitride or nickel, etc. In another embodiment, when the ion implantation energy is below 600 kev, a photoresist may be coated on the surface of the N-type epitaxial layer 202 as the mask layer 203. A pattern is then formed through a photoetching mask and an etching process to define a region where a N-type implantation region is to be formed. It can be understood that the formation of the mask layer 203 is determined by an energy value of the ion implantation by using the inorganic thin film material generated by means of CVD or coating the photoresist, which is not limited herein.
(3) The ions are implanted to form an N-type implantation region 204. Referring to FIG. 2c, in some embodiments, nitrogen ions or phosphorus ions are implanted into part of region of the N-type epitaxial layer 202 at a first energy of 500 kev to 2000 kev and a first concentration of 1E13 to 3E14 atoms per square centimeter, as well as at a second energy of 50 kev to 300 kev and a second concentration of 1E12 to 5E13 atoms per square centimeter, along the C-axis direction (as shown in FIG. 3, for 4H-SiC, an included angle between the C-axis direction and a normal direction of the 4H-SiC wafer is 4 degrees) of silicon carbide to form the N-type implantation region 204. Due to the channel effect, nitrogen ions or phosphorus ions can be implanted to a sufficiently deep depth to obtain the sufficiently deep N-type implantation region 204, which greatly reduces the number of ion implantations and implantation energy, and reduces the manufacturing cost.
   It should be noted that the depth of the N-type implantation region 204 in FIG. 2c is smaller than the depth of the N-type epitaxial layer 202. However, in other embodiments of the present application, the depth of the N-type implantation region 204 may be equal to the depth of the N-type epitaxial layer 202. That is, the entire N-type epitaxial layer 202 is completely implanted with doping ions to form the N-type implantation region, which is not limited herein.
(4) A mask layer 205 is formed. Referring to FIG. 2d, in one embodiment, an inorganic thin film material that can be generated on the surface of the N-type implantation region 204 by means of chemical vapor deposition (CVD) is used as the hard mask layer 205. The components of the inorganic thin film material include, but are not limited to, silicon dioxide, silicon nitride or nickel, etc. In another embodiment, when the ion implantation energy is below 600 kev, a photoresist may be coated on the surface of the N-type implantation region 204 as the mask layer 205. A pattern is then formed through a photoetching mask and an etching process to define a region where a P-type column is to be formed. It can be understood that the formation of the mask layer 205 is determined by an energy value of the ion implantation by using the inorganic thin film material generated by means of CVD or coating the photoresist, which is not limited herein.
(5) The ions are implanted to form the P-type column 206. Referring to FIG. 2e, in some embodiments, aluminum ions (e.g., AI-27) are implanted into part of the N-type implantation region 204 at a third energy of 500 kev to 2000 kev and a third concentration of 5E13 to 3E14 atoms per square centimeter, as well as at a fourth energy of 50 kev to 300 kev and a fourth concentration of 5E12 to 5E13 atoms per square centimeter, along the C-axis direction of silicon carbide to form the P-type column 206; and the P-type column 206 forms a super junction with a region, that is not doped with aluminum ions, in the N-type implantation region 204. Due to the channel effect, aluminum ions (e.g., AI-27) can be implanted to a sufficiently deep depth to obtain the sufficiently deep P-type column 206, which greatly reduces the number of ion implantations and implantation energy, and reduces the manufacturing cost.
(6) The ions are implanted to form a P+ implantation region 207. Referring to FIG. 2f, in some embodiments, aluminum ions (e.g., AI-27) are implanted into the P-type column 206 at a fifth energy of 80 kev to 200 kev and a fifth concentration of 5E13 to 3E14 atoms per square centimeter, as well as at a sixth energy of 20 kev to 70 kev and a sixth concentration of 5E13 to 5E14 atoms per square centimeter, along a normal direction of a silicon carbide wafer (as shown in FIG. 3, the normal direction is perpendicular to a main plane of the silicon carbide wafer) to form the P+ implantation region 207, wherein the P+ implantation region 207 can shield a surface electric field of the power semiconductor device, that is, reduce a surface electric field strength, reduce a reverse leakage current, and then increase a reverse breakdown voltage, thereby making the reverse breakdown voltage of the super-junction Schottky diode larger, and can thus be applied in high-voltage fields.
(7) High-temperature annealing is performed. By exposing the power semiconductor device in FIG. 2f to a high temperature for a period of time and then slowly cooling it, all the implanted N-type and P-type doping ions above can be activated by high-temperature annealing.
(8) An electrode 208 and a surface passivation layer 209 are formed. Referring to FIG. 2g, a conventional ohmic contact process, a Schottky contact process, a metallization process, etc. can be performed on the power semiconductor device to form the electrode 208, wherein the electrode 208 and the N-type implantation region 204 form a Schottky junction. It can be understood that the Schottky junction is a simple metal-semiconductor contact interface, and similar to a PN junction, has a nonlinear impedance characteristic. Then, a passivation treatment is performed on the surface of the electrode 208 to form the passivation layer 209, so as to improve the stability and reliability of the electrical performance of the super-junction Schottky diode.

It should be noted that all the values the number of times of ion implantations, corresponding energy and concentration mentioned above are exemplary, but not limitative. In other embodiments of the present application, the number of the implantation times, corresponding energy and concentration may be selected according to the required implantation depth.

It should be noted that the implantation from the C-axis direction of the 4H-SiC wafer among all the above-mentioned ion implantations is exemplary, but not limitative. In other embodiments of the present application, the ions may be implanted into the epitaxial layer along a crystal orientation of other wide-bandgap semiconductors, so as to utilize the channel effect to reduce the implantation energy, thereby achieving a deeper implantation depth.

It should be noted that the manufacturing method of the super junction of the power semiconductor device described above in conjunction with the embodiments of the present application can be applied to other power semiconductor device structures other than Schottky diodes, such as a junction field-effect transistor (JFET) and a metal-oxide-semiconductor field-effector transistor (MOSFET), which are not limited herein.

In the drawings, some structural or method features may be shown in specific arrangements and/or sequences. It should be understood, however, that such specific arrangements and/or sequences may not be required. Rather, in some embodiments, these features may be arranged in a manner and/or sequence different from that shown in the illustrative drawings. Additionally, the inclusion of a structural or method feature in a particular drawing is not meant to imply that such feature is required in all embodiments. In addition, in some embodiments, these features may not be included or may be combined with other features.

It should be noted that each unit/apparatus mentioned in each device embodiment of this application is a logical unit/apparatus. Physically, a logical unit/apparatus may be a physical unit/apparatus, or a part of a physical unit/apparatus, and may also be implemented by a combination of multiple physical units/apparatuses. The physical implementation manner of these logical units/apparatuses themselves is not the most important, and the combination of functions implemented by these logical units/apparatuses is the key to solve the technical problems proposed by the present application. Furthermore, in order to highlight the innovative part of the present application, the device embodiments of the present application do not introduce a unit/apparatus that is not closely related to solving the technical problems proposed by the present application, but do not mean that there are no other units/apparatuses in the device embodiments.

It should be noted that, as used in the examples and description of this patent, relation terms such as "first" and "second" are used merely to distinguish a subject or an operation from another subject or another operation, and not to require or imply any substantial relation or sequence between these subjects or operations. Moreover, terms "include", "contain" or any variation thereof are intended to cover a nonexclusive containing, such that a process, a method, an item or a device containing a series of elements not only includes these elements, but also includes other elements that are not set forth specifically, or also includes an inherent element of such a process, method, item or device. Without further limitation, an element defined by a phrase "include a" does not mean that other elements are excluded from the process, method, item or device including the same element. While the present application has been illustrated and described with reference to certain preferred embodiments of the present application, it will be understood by those of ordinary skill in the art that various changes in form and details may be made therein without departing from the spirit and scope of the present application.

## Claims

1. A manufacturing method of a super junction, **characterized by** comprising:
forming an epitaxial layer on the surface of a wide-bandgap semiconductor substrate by an epitaxial growth process;
implanting first doping ions into at least one part of region of the epitaxial layer along a preset crystal orientation of the wide-bandgap semiconductor to form a first conductive type region; and
implanting second doping ions into at least part of the first conductive type region along the preset crystal orientation of the wide-bandgap semiconductor to form a second conductive type region, wherein the second doping ions and the first doping ions have different conductive types; and
the preset crystal orientation is a crystal orientation which enables the doping ions to generate a channel effect when the doping ions are implanted along the preset crystal orientation.

2. The method according to claim 1, **characterized in that** the wide-bandgap semiconductor is silicon carbide, and the preset crystal orientation of the wide-bandgap semiconductor is a C-axis direction of the silicon carbide.

3. The method according to claim 2, **characterized in that** the silicon carbide comprises 4H-SiC or 6H-SiC.

4. The method according to claim 1 or 2, **characterized in that** the step of implanting the first doping ions into at least part of region of the epitaxial layer along the preset crystal orientation of the wide-bandgap semiconductor comprises:
implanting the first doping ions into at least part of the epitaxial layer along the crystal direction of the wide-bandgap semiconductor at a first concentration and a first energy, as well as at a second concentration and a second energy, respectively.

5. The method according to claim 4, **characterized in that** the first concentration is 1E13 to 3E14 atoms per square centimeter, and the first energy is 500 kev to 2000 kev; and the second concentration is 1E12 to 5E13 atoms per square centimeter, and the second energy is 50 kev to 300 kev.

6. The method according to claim 1 or 2, **characterized in that** the step of implanting the second doping ions into at least part of the first conductive type region along the crystal orientation of the wide-bandgap semiconductor comprises:
implanting the second doping ions into the epitaxial layer along the crystal direction of the wide-bandgap semiconductor at a third concentration and a third energy, as well as a fourth concentration and a fourth energy respectively.

7. The method according to claim 6, **characterized in that** the third concentration is 5E13 to 3E14 atoms per square centimeter, and the third energy is 500 kev to 2000 kev; and the fourth concentration is 5E12 to 5E13 atoms per square centimeter, and the fourth energy is 50 kev to 300 kev.

8. The method according to claim 1, **characterized in that** the first doping ions include nitrogen ions or phosphorus ions.

9. The method according to claim 1, **characterized in that** the second doping ions include aluminum ions or boron ions.

10. A super-junction Schottky diode, **characterized by** comprising:
an epitaxial layer formed on the surface of a wide-bandgap semiconductor substrate by an epitaxial growth process;
a first conductive type region formed by implanting first doping ions into at least part of region of the epitaxial layer along a preset crystal orientation of the wide-bandgap semiconductor;
a second conductive type region formed by implanting the second doping ions into at least part of the first conductive type region along the preset crystal orientation of the wide-bandgap semiconductor; and
a metal layer disposed on at least part of the surface of the first conductive type region away from the substrate, such that the metal layer and the first conductive type region form a Schottky junction,
wherein the preset crystal orientation is a crystal orientation which enables the doping ions to generate a channel effect when the doping ions are implanted along the preset crystal orientation.

11. The super-junction Schottky diode according to claim 10, **characterized by** further comprising a second conductive type implantation region formed by implanting the second doping ions into part of the second conductive type region along a normal direction of the wide-bandgap semiconductor.

12. The super-junction Schottky diode according to claim 10, **characterized in that** the wide-bandgap semiconductor is silicon carbide.

13. The super-junction Schottky diode according to claim 10, **characterized in that** the silicon carbide comprises 4H-SiC or 6H-SiC.

14. The super-junction Schottky diode according to claim 10, **characterized in that** the first ions include nitrogen ions or phosphorus ions; and the nitrogen ions or phosphorus ions are implanted into at least part of region of the epitaxial layer along a C-axis direction of the silicon carbide semiconductor at a first concentration and a first energy, as well as at a second concentration and a second energy, respectively.

15. The super-junction Schottky diode according to claim 10 or 12, **characterized in that** the second doping ions include aluminum ions or boron ions; and the aluminum ions or boron ions are implanted into at least part of the first conductive type region along the C-axis direction of the silicon carbide semiconductor at a third concentration and a third energy, as well as at a fourth concentration and a fourth energy, respectively.

16. The super-junction Schottky diode according to claim 11 or 12, **characterized in that** the second doping ions include aluminum ions; and the aluminum ions are implanted into part of the second conductive type region along a normal direction of the wide-bandgap semiconductor at a fifth concentration and a fifth energy, as well as at a sixth concentration and a sixth energy, respectively.
